(19) **Europäisches Patentamt / European Patent Office / Office européen des brevets**

(11) **EP 4 395 094 B1**

(12) # EUROPEAN PATENT SPECIFICATION

(45) Date of publication and mention
of the grant of the patent:
**08.04.2026 Bulletin 2026/15**

(21) Application number: **21964460.6**

(22) Date of filing: **22.11.2021**

(51) International Patent Classification (IPC):
*H02P 9/00* (2006.01)   *H02J 3/00* (2026.01)
*H02J 3/28* (2026.01)   *H02J 3/24* (2006.01)
*H02J 3/38* (2026.01)   *H02J 15/00* (2026.01)

(52) Cooperative Patent Classification (CPC):
**H02J 3/28; H02J 15/30; H02P 9/007**

(86) International application number:
**PCT/CN2021/132110**

(87) International publication number:
**WO 2023/087311 (25.05.2023 Gazette 2023/21)**

(54) **METHOD FOR DETERMINING CAPACITY OF ENERGY STORAGE APPARATUS FOR NEW ENERGY SUPPORT MACHINE, AND NEW ENERGY SUPPORT MACHINE**

VERFAHREN ZUR BESTIMMUNG DER KAPAZITÄT EINER ENERGIESPEICHERVORRICHTUNG FÜR EINE NEUE ENERGIEUNTERSTÜTZUNGSMASCHINE UND NEUE ENERGIEUNTERSTÜTZUNGSMASCHINE

PROCÉDÉ POUR DÉTERMINER LA CAPACITÉ D'UN APPAREIL DE STOCKAGE D'ÉNERGIE POUR UNE NOUVELLE MACHINE DE SUPPORT D'ÉNERGIE, ET NOUVELLE MACHINE DE SUPPORT D'ÉNERGIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.11.2021 CN 202111372635**

(43) Date of publication of application:
**03.07.2024 Bulletin 2024/27**

(73) Proprietor: **China Electric Power Research Institute**
**Beijing 100192 (CN)**

(72) Inventors:
• **SUN, Huadong**
  **Beijing 100192 (CN)**
• **ZHANG, Jian**
  **Beijing 100192 (CN)**
• **LI, Wenfeng**
  **Beijing 100192 (CN)**
• **WEI, Wei**
  **Beijing 100192 (CN)**
• **LI, Zhiqiang**
  **Beijing 100192 (CN)**

• **WANG, Hui**
  **Beijing 100192 (CN)**
• **AI, Dongping**
  **Beijing 100192 (CN)**
• **JIA, Yuan**
  **Beijing 100192 (CN)**
• **SUN, Hangyu**
  **Beijing 100192 (CN)**

(74) Representative: **White, Andrew John et al**
**Mathys & Squire**
**The Shard**
**32 London Bridge Street**
**London SE1 9SG (GB)**

(56) References cited:
**CN-A- 103 414 209    CN-A- 107 546 772**
**CN-A- 108 879 779    CN-A- 112 383 071**
**CN-A- 112 383 071**

- **QU SHENGWEI ET AL: "The Coordinated Control Strategy of Doubly-fed Induction Generators With an Energy Storage Dynamic Voltage Restorer for Low Voltage Ride Through", 2019 6TH INTERNATIONAL CONFERENCE ON SYSTEMS AND INFORMATICS (ICSAI), IEEE, 2 November 2019 (2019-11-02), pages 286 - 291, XP033724366, DOI: 10.1109/ ICSAI48974.2019.9010522**

- **LI RAN ET AL: "Analysis of Electromechanical Interactions in a Flywheel System With a Doubly Fed Induction Machine", IEEE TRANSACTIONS ON INDUSTRY APPLICATIONS, IEEE SERVICE CENTER, PISCATAWAY, NJ, US, vol. 47, no. 3, May 2011 (2011-05-01), pages 1498 - 1506, XP011477798, ISSN: 0093-9994, DOI: 10.1109/ TIA.2011.2127436**

**Description**

CROSS-REFERENCE TO RELATED APPLICATIONS

TECHNICAL FIELD

The disclosure relates to the field of power system operation and control technology, and in particular to a method and an apparatus for determining a capacity of an energy storage apparatus for a new energy support machine, and a new energy support machine.

BACKGROUND

The power grid construction of China is complex. There are the interaction between Alternating Current (AC) and Direct Current (DC), between multiple DC, and between the sending and receiving ends, and operation characteristics of the power grid are complex, which increase control difficulty and causes power grid simulation to face a severe test. Furthermore, in a power grid with a high proportion of new energy, characteristics of the new energy are very obvious, and the security problem of the new energy grid connection is very serious. Especially, in a near-area power grid at an ultra-high voltage DC sending end, proportion of the new energy convergence is high, and clustering is obvious. The problems of voltage, inertia, and primary frequency adjustment of the power system are getting more and more serious. For example, on August 9, 2019, due to a certain reason, the Little Barford gas power station in Britain was correctly shut down, but loss of generating load led to a decrease in the system frequency. In addition, since wind turbines of the North Sea power grid had an insufficient capacity to tolerate low frequency, a large number of wind turbines were disconnected, and the output of the wind farm plummeted, which in turn led to a sudden drop in the system frequency and a low-frequency load-shedding action. A part of load was removed and a blackout accident occurred.

Currently, most generating units in a power system, such as a thermal power unit, a hydropower unit, a gas unit, a thermoelectric unit, a nuclear power unit, a pumped storage unit, a solar thermal unit, or the like, may provide a primary frequency adjustment capacity when there is a rapid change in the system frequency of the system frequency.

However, wind power generators in the wind farms, or power equipment in photovoltaic or other new energy station do not have a primary frequency adjustment capability. On the whole, the inertia support of the new energy station is insufficient, and the adjustment capability is not strong. In a power grid with a high proportion of the new energy, the power grid security problem caused by the new energy grid connection is relatively serious. Related technologies can be found at least in patent document CN112383071A, which discloses the features of the preamble of claims 1 and 6, and in non-patent documents "The Coordinated Control Strategy of Doubly-fed Induction Generators With an Energy Storage Dynamic Voltage Restorer for Low Voltage Ride Through" XP033724366, and "Analysis of Electromechanical Interactions in a Flywheel System With a Doubly Fed Induction Machine" XP011477798.

SUMMARY

Aiming at the deficiencies of the related art, the disclosure provides a method and an apparatus for determining a capacity of an energy storage apparatus for a new energy support machine, and a new energy support machine, which is intended to solve the problem of an insufficient adjustment capacity of a new energy station at present. The present invention is set out in the appended set of claims.

With the method and the apparatus for determining a capacity of an energy storage apparatus for a new energy support machine, and the new energy support machine provided by the disclosure, the capacity of the energy storage apparatus is determined according to the active power when the stator of the doubly-fed asynchronous generator participates in the adjustment, the slip ratio of the rotor when the rotor participates in the adjustment, and the duration for which the rotor participates in the adjustment. The method is intuitive and has a small calculation amount, and the determined capacity value is larger and more reliable, so that the engineering practicability is higher. By configuring an electrochemical energy storage apparatus with the capacity into a new energy support machine, the adjustment capability of the new energy station may be improved.

BRIEF DESCRIPTION OF THE DRAWINGS

The drawings here are incorporated into the specification and form a part of the specification, which illustrate embodiments consistent with the disclosure, and are used in conjunction with the specification to explain the principles of the disclosure.

FIG. 1 is a flowchart of a method for determining a capacity of an energy storage apparatus for a new energy support machine of a preferred implementation of the disclosure.

FIG. 2 is a schematic composition diagram of an apparatus for determining a capacity of an energy storage apparatus for a new energy support machine of a preferred implementation of the disclosure.

FIG. 3 is a typical schematic diagram of a new energy support machine of a preferred implementation of the disclosure.

FIG. 4 is a schematic connection diagram of an energy storage apparatus for a new energy support machine of a preferred implementation of the disclosure.

DETAILED DESCRIPTION

Exemplary implementations of the disclosure are now introduced with reference to the drawings. However, the disclosure may be implemented in many different forms and is not limited to the embodiments described herein. The embodiments are provided to exhaustively and completely disclose the disclosure and to fully convey the scope of the disclosure to those skilled in the art. Terms in the exemplary implementations indicated in the drawings are not limitation on the disclosure. In the drawings, the same units/components are labeled with the same reference signs.

Unless otherwise indicated, terms (including technical terms) used herein have commonly understood meanings to those skilled in the art. Further, it is to be understood that a term qualified by commonly used dictionaries should be understood as having a meaning consistent with the context of its related art, and should not be understood as an idealized or overly formal meaning.

The following are definitions of some terms and symbols.

State of charge, called SOC for short.

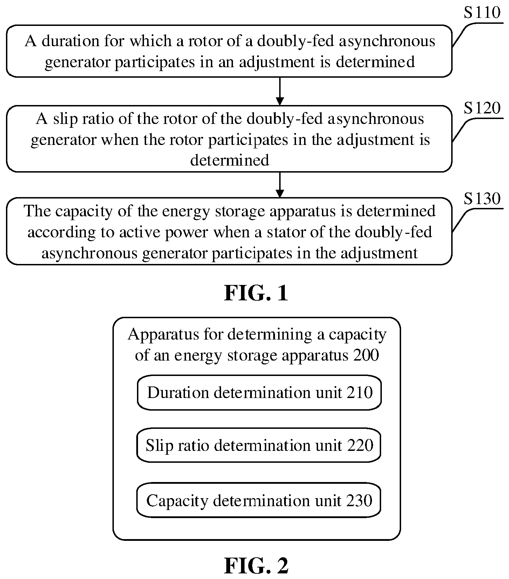

As shown in FIG. 1, a method for determining a capacity of an energy storage apparatus for a new energy support machine of an embodiment of the disclosure includes the following operations.

In operation S110, a duration for which a rotor of a doubly-fed asynchronous generator participates in an adjustment is determined.

In operation S120, a slip ratio of the rotor of the doubly-fed asynchronous generator when the rotor participates in the adjustment is determined.

In operation S130, the capacity of the energy storage apparatus is determined according to active power when a stator of the doubly-fed asynchronous generator participates in the adjustment, the slip ratio of the rotor when the rotor participates in the adjustment, and the duration for which the rotor participates in the adjustment.

In some optional implementations, the operation that the duration for which the rotor of the doubly-fed asynchronous generator participates in the adjustment is determined includes the following operations.

A maximum time period of energy release by the rotor of the doubly-fed asynchronous generator is determined according to a lower threshold of an angular velocity of the rotor of the doubly-fed asynchronous generator.

A maximum time period of energy absorption by the rotor of the doubly-fed asynchronous generator is determined according to an upper threshold of the angular velocity of the rotor of the doubly-fed asynchronous generator.

A larger one of the maximum time period of energy release and the maximum time period of energy absorption is determined as the duration for which the rotor participates in the adjustment.

In some optional implementations, the operation that the slip ratio of the rotor of the doubly-fed asynchronous generator when the rotor participates in the adjustment is determined includes the following operations.

An angular velocity of the rotor when the rotor participates in the adjustment is determined according to a kinetic equation of the rotor of the doubly-fed asynchronous generator.

The slip ratio of the rotor when the rotor participates in the adjustment is determined according to a rated angular velocity of the rotor of the doubly-fed asynchronous generator and the angular velocity of the rotor when the rotor participates in the adjustment.

In some optional implementations, the method further includes the following operation.

The active power when the stator participates in the adjustment is determined according to an obtained to-be-adjusted frequency deviation of a system frequency and a frequency-active adjustment coefficient corresponding to the doubly-fed asynchronous generator.

In some optional implementations, the operation that the capacity of the energy storage apparatus is determined includes the following operation.

The active power when the stator participates in the adjustment and the slip ratio of the rotor when the rotor participates in the adjustment are integrated during the duration for which the rotor participates in the adjustment to obtain an integral result. The integral result is the capacity of the energy storage apparatus.

In some optional implementations, the capacity of the energy storage apparatus is an integral value of active power flowing through the rotor over time within the duration for which the rotor of the doubly-fed asynchronous generator participates in the adjustment.

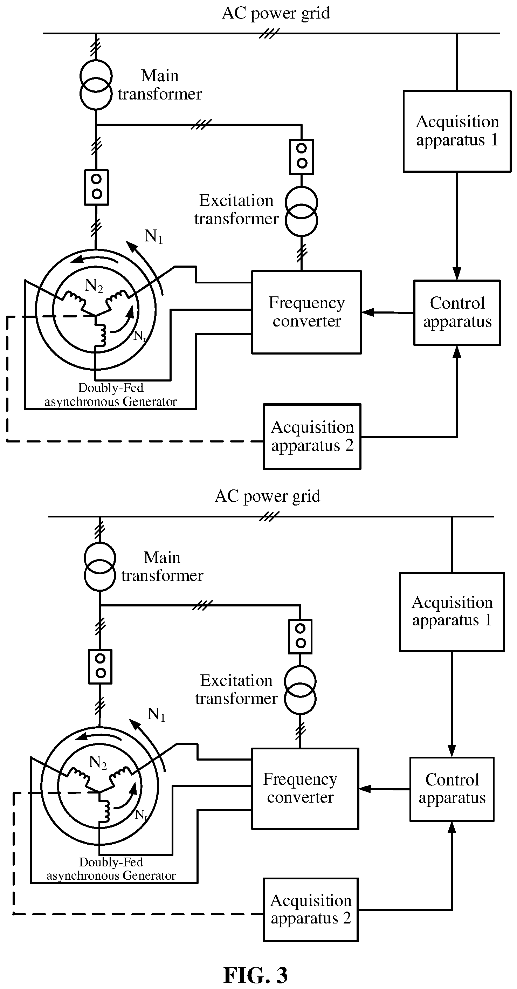

When a power imbalance occurs in a power system, it is necessary to connect a primary frequency adjustment device to the power grid in time to suppress a rapid change in the system frequency. A new energy support machine disposed at a grid connection point of a new energy station may be connected to the power grid at the primary frequency adjustment stage to provide a primary frequency adjustment capability. As shown in FIG. 3, the new energy support machine controllably releases the active power to the power grid or absorbs the active power from the power grid according to the received primary frequency adjustment instruction, thereby suppressing the rapid change of the system frequency and improving the frequency adjustment capability of the new energy station.

As shown in FIG. 3, the new energy support machine includes a doubly-fed asynchronous generator, a frequency converter, a control apparatus for realizing the primary frequency adjustment control, an acquisition apparatus 2 for obtaining the rotational speed N of the rotor, and an acquisition apparatus 1 for obtaining the system frequency. The doubly-fed asynchronous generator includes a stator and a rotor located inside the stator winding. The stator of the doubly-fed asynchronous generator is connected to the AC power grid through a main transformer. The rotor of the doubly-fed asynchronous generator, the frequency converter and the excitation transformer are connected sequentially to the secondary side of the main transformer, and then the rotor of the doubly-fed asynchronous generator is connected to the AC power grid. The frequency converter consists of an AC-DC-AC link, and includes a grid-side converter (which has an AC side and a DC side) and a machine-side converter (which has a DC side and an AC side).

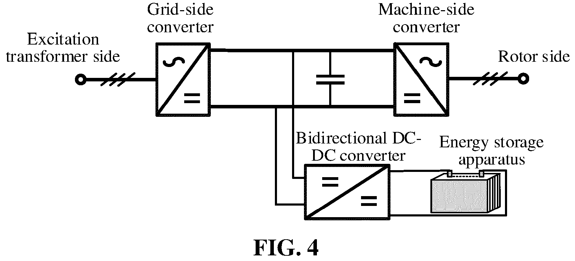

As shown in FIG. 3 and FIG. 4, the grid-side converter is connected to the excitation transformer and the machine-side converter is connected to the rotor of the doubly-fed asynchronous generator. The frequency converter adopts fully-controlled components, and may independently control at least one of the reactive power or thes active power flowing through the rotor or stator of the doubly-fed asynchronous generator respectively.

As shown in FIG. 3, the doubly-fed asynchronous generator is AC excited, and the rotor and the stator are coupled through a magnetic gap. The machine-side converter controls the active power or the reactive power flowing through the stator of the doubly-fed asynchronous generator by controlling the active power or the reactive power flowing through the rotor of the doubly-fed asynchronous generator. Specifically, the active power $P_r$ flowing through the rotor of the doubly-fed asynchronous generator and the active power $P_e$ flowing through the stator of the doubly-fed asynchronous generator satisfy the following relationship: $P_r = {}_sP_e$. Here, s is the slip ratio of the rotor of the doubly-fed asynchronous generator.

Specifically, when the frequency of the power system changes rapidly due to unbalanced power, the control apparatus executes the primary frequency adjustment instruction obtained from an upper dispatching system to generate a power adjustment value, and controls the frequency converter (from the grid-side converter to the machine-side converter) to execute the power adjustment value, such that the stator and rotor of the doubly-fed asynchronous generator release the active power and the energy to the AC power grid, or absorb the active power and the energy from the AC power grid, thereby suppressing the rapid change of the frequency of the power system and improving the frequency adjustment capability of the new energy station.

During the dynamic process that the new energy support machine participates in the primary frequency adjustment, the control apparatus executes the primary frequency adjustment instruction obtained from the upper dispatching system, generates the power adjustment value, and controls the frequency converter (from the grid-side converter to the machine-side converter) to execute the power adjustment value $P_e$, such that the value of the active power flowing through the stator of the doubly-fed asynchronous generator is $P_e$:

$$P_e = k\Delta f.$$

Here, $\Delta f$ is a to-be-adjusted frequency deviation of the system frequency, and is positive or negative. K is a frequency-active adjustment coefficient, and is constant for a certain type of new energy support machine.

In a specific implementation, the lowest frequency for the safe operation of the power system is the lower threshold of the permissible frequency deviation range of the power system, and the highest frequency for the safe operation of the power system is the upper threshold of the permissible frequency deviation range of the power system. In other words, the to-be-adjusted frequency deviation of the system frequency is not larger than the difference (which is a positive value) between the highest frequency for the safe operation of the power system and the rated frequency, and is not less than the difference (which is a negative value) between the lowest frequency for the safe operation of the power system and the rated frequency.

Therefore, according to the above equation, when the to-be-adjusted frequency deviation of the system frequency is selected as the difference between the highest frequency for the safe operation of the power system and the rated frequency, the instruction value of the active power obtained from the upper dispatching department is a first upper threshold of the active power. When the to-be-adjusted frequency deviation of the system frequency is selected as the difference between the lowest frequency for the safe operation of the power system and the rated frequency, the instruction value of the active power obtained from the upper dispatching department is a second upper threshold of the active power. The larger one of the first upper threshold of the active power and the second upper threshold of the active power is determined as the maximum value of the active power flowing through the stator of the doubly-fed asynchronous generator.

As shown in FIG. 4, the new energy support machine further includes an electrochemical energy storage apparatus, a bidirectional DCDC converter and an energy storage control unit (not shown in the figure). The electrochemical energy storage apparatus is connected to the DC side of the frequency converter through the bidirectional DCDC converter. The energy storage control unit receives and executes the charging and discharging instruction generated and distributed by the control apparatus, generates an electrical power adjustment instruction, and controls the bidirectional DCDC converter to execute the electrical power adjustment instruction, such that the active power flowing through the rotor of the doubly-fed asynchronous generator charges the energy storage apparatus or discharges the energy storage apparatus through the bidirectional DCDC converter.

Overall, during the process of the primary frequency adjustment, the active power $P_r$ and energy flowing through the rotor of the doubly-fed asynchronous generator are converted into the increased SOC and electrical energy of the energy storage apparatus, or the decreased SOC and electrical energy of the energy storage apparatus are converted into the active power $P_r$ and energy flowing through the rotor of the doubly-fed asynchronous generator. In other words, during the process of the primary frequency adjustment, the active power $P_r$ and energy flowing through the rotor of the doubly-fed asynchronous generator are absorbed or released by the electrochemical energy storage apparatus.

When the new energy support machine participates in the primary frequency adjustment, the stator of the doubly-fed asynchronous generator absorbs the active power $P_e$ from the AC power grid, or releases the active power $P_e$ to the AC power grid. When the stator of the doubly-fed asynchronous generator absorbs the active power from the AC power grid, the angular velocity of the rotor increases continuously, i.e., the kinetic energy of the rotor increases continuously. When the stator of the doubly-fed asynchronous generator releases the active power to the AC power grid, the angular velocity of the rotor decreases continuously, i.e., the kinetic energy of the rotor decreases continuously.

In summary, during the process that the power system responds to imbalanced disturbance of active power, the new energy support machine participates in the process of the primary frequency adjustment, and overall, absorbs electrical power from the power system or releases electrical power to the power system. Accordingly, the rotor of the doubly-fed asynchronous generator also absorbs or releases a corresponding amount of energy (which is the kinetic energy), and the energy storage apparatus also absorbs or releases a certain amount of energy (which is the electrochemical energy). In addition, the rotor of the doubly-fed asynchronous generator and the energy storage apparatus simultaneously participate in the primary frequency adjustment and simultaneously exit from the primary frequency adjustment. That is, the both participate in the primary frequency adjustment for the same duration.

A method for determining the capacity of the energy storage apparatus by integration over time according to the active power flowing through the rotor of the doubly-fed asynchronous generator and the duration of the primary frequency adjustment is specifically illustrated in the following.

According to Newton's law of motion, the kinetic equation of the rotor of the doubly-fed asynchronous generator is shown in equation (1).

$$T_m - T_e - D\omega = J\frac{d\omega}{dt} \qquad (1)$$

Here, $T_e$ is the electromagnetic torque of the rotor. D is the frictional coefficient of the rotor. J is the moment of inertia of the rotor. $\omega$ is the angular velocity or rotational speed of the rotor (in rad/s or r/min). $T_m$ is the mechanical torque of the rotor.

The frictional coefficient D is related to factors such as brushes, bearings, air resistance, or the like, and is a constant or a function with the angular velocity as the independent variable, which may be determined according to the design manual or manufacturer's product manual. The moment of inertia J of the rotor may be obtained by measurement or calculation, for example, may be determined according to the design manual or manufacturer's product manual.

When used as a new energy support machine, the rotor of the doubly-fed asynchronous generator has no mechanical torque from other prime motors, and $T_m = 0$. In such case, the equation (1) is adjusted to equation (2).

$$-T_e - D\omega = J\frac{d\omega}{dt} \qquad (2)$$

Both sides of the equation (2) are multiplied by the angular velocity $\omega$ of the rotor, and equation (3) is obtained.

$$-T_e\omega - D\omega^2 = J\omega\frac{d\omega}{dt} \qquad (3)$$

As shown in equation (4), the product of the electromagnetic torque $T_e$ of the rotor and the angular velocity $\omega$ of the rotor is the active power $P_e$ flowing through the stator of the doubly-fed asynchronous generator.

$$P_e = T_e \omega \qquad (4)$$

The equation (4) is substituted into the equation (3), and equation (5) is obtained.

$$-P_e - D\omega^2 = J\omega \frac{d\omega}{dt} \qquad (5)$$

It is to be understood that, in order to simplify the representation, in the above equation (1) to equation (5), the time variables, such as the electromagnetic torque $T_e$ of the rotor, the angular velocity $\omega$ of the rotor, the active power $P_e$ flowing through the stator of the doubly-fed asynchronous generator, or the like, are not additionally attached with a time mark t.
If the start moment of the primary frequency adjustment is taken as the zero moment, t=0. Thus, in the initial state, the rotor operates stably at the rated angular velocity $\omega_N$. The differential equation (5) is solved taking the rated angular velocity $\omega_N$ of the rotor as the initial value, and the angular velocity $\omega$ of the rotor during the dynamic process of the primary frequency adjustment is found as follows.

$$\omega = \sqrt{\frac{(t - \frac{J\ln(P_e + D\omega_N^2)}{2D})e^{-\frac{2D}{J}} - P_e}{D}} \qquad (6)$$

In specific implementation, in order to simplify the calculation, in the equation (6) and other equations thereafter, a constant value is adopted for the time-varying active power $P_e$, for example, the permissible maximum active power flowing through the stator of the doubly-fed asynchronous generator.
During the dynamic process of the primary frequency adjustment, the slip ratio s of the rotor (which is a time variable and dimensionless) is calculated according to equation (7).

$$s = \frac{\omega_N - \omega}{\omega_N} \qquad (7)$$

When the angular velocity of the rotor is the rated angular velocity $\omega_N$, the value of the slip ratio s of the rotor is 0. In engineering practice, the slip ratio s of the rotor of the doubly-fed asynchronous generator is generally within the range of ±0.3. That is, the upper threshold is 0.3, and the lower threshold is -0.3.
According to the number of pole pairs of the doubly-fed asynchronous generator and the rated system frequency $f_n$ of the power grid, the rated angular velocity $\omega_N$ of the rotor of the doubly-fed asynchronous generator may be determined according to the following equation.

$$\omega_N = 60 f_n / p \qquad (9)$$

Here, as an example, the rated frequency $f_n$ of the AC power grid is 50 Hz. p is the number of pole pairs of the rotor of the doubly-fed asynchronous generator, and is generally 1, 2, or 3.
Referring to the aforementioned illustration, the active power $P_r$ flowing through the rotor of the doubly-fed asynchronous generator is s times the active power $P_e$ flowing through the stator, and thus the active power $P_r$ flowing through the rotor is as follows.

$$P_r = sP_s = sP_e$$

$$= \frac{\omega_N - \sqrt{\dfrac{(t - \dfrac{J\ln(P_e + D\omega_N^2)}{2D})e^{-\frac{2D}{J}} - P_e}{D}}}{\omega_N} P_e \qquad (8)$$

The active power $P_r$ flowing through the rotor of the doubly-fed asynchronous generator is controlled to be injected into the energy storage apparatus or is obtained by being absorbed from the energy storage apparatus. Therefore, during the process of participating in the primary frequency adjustment, the capacity Ss of the energy storage apparatus may be determined according to the following equation.

$$S_s = \int_{t=0}^{t_{max}} P_r dt$$

$$= \int_{t=0}^{t_{max}} \frac{\omega_N - \sqrt{\dfrac{(t - \dfrac{J\ln(P_e + D\omega_N^2)}{2D})e^{-\frac{2D}{J}} - P_e}{D}}}{\omega_N} P_e dt \qquad (9)$$

Regarding the left side of the above equation, the unit of energy is joule (J) or kWh. Regarding the right side of the above equation, the unit of power is watt (W). In the above equation, the upper threshold of the integration time is denoted as $t_{max}$.

When the active power $P_e$ adopts the permissible maximum active power flowing through the stator of the doubly-fed asynchronous generator, in the equation (9), the larger the value of the upper threshold of the integration time $t_{max}$, the larger the determined capacity value of the energy storage apparatus is. By configuring an electrochemical energy storage apparatus with a corresponding capacity into the new energy support machine according to the capacity value, a case, in which it is necessary to release electrical energy from the energy storage apparatus in the primary frequency adjustment while the energy storage apparatus is already at the minimum SOC and cannot continue to be discharged, may be avoided; or a case, in which it is necessary for the energy storage apparatus to absorb electrical energy in the primary frequency adjustment while the energy storage apparatus is already at the maximum SOC and cannot continue to be charged, may be avoided.

Referring to the aforementioned illustration, the rotor of the doubly-fed asynchronous generator and the energy storage apparatus participate in the primary frequency adjustment for the same duration. Therefore, the maximum duration for which the energy storage apparatus participates in the primary frequency adjustment may be determined through the duration of the process that the rotor participates in the primary frequency adjustment, and is then taken as the upper threshold of the integration time $t_{max}$. The determination of the duration of the process that the rotor participates in the primary frequency adjustment may be achieved by determining a changed value of the kinetic energy during the process that the rotor participates in the primary frequency adjustment.

During the dynamic process of participating in the primary frequency adjustment of the power grid, the adjustable range of the angular velocity $\omega$ of the rotor is controlled to satisfy the following constraints: $\omega_{min} < \omega < \omega_{max}$. Here, $\omega_{max}$ is the upper threshold of the angular velocity and $\omega_{min}$ is the lower threshold of the angular velocity.

Referring to the aforementioned illustration, the active power $P_r$ flowing through the rotor of the doubly-fed asynchronous generator is s times the active power $P_e$ flowing through the stator. Therefore, in the first case, the difference between the active power $P_e$ flowing through the stator of the doubly-fed asynchronous generator and the active power $P_r$ flowing through the rotor of the doubly-fed asynchronous generator is derived from the decreased angular acceleration and rotational momentum of the rotor, and is accumulated as the decreased kinetic energy of the rotor during the whole process of the primary frequency adjustment. In such case, during the process of the primary frequency adjustment, the angular velocity of the rotor of the new energy support machine is in a monotonically decreasing dynamic process, and the slip ratio is a negative value that is less than 0 and larger than the lower threshold. When the active power $P_e$ adopts the permissible maximum active power flowing through the stator of the doubly-fed asynchronous generator, during the process of the primary frequency adjustment, in a limiting case that the angular velocity of the rotor decreases from the initial state (rated angular velocity $\omega_N$) to the lower threshold of angular velocity $\omega_{min}$, the kinetic energy of the rotor of the doubly-fed asynchronous generator decreases the most, and the primary frequency adjustment lasts for the longest time period. In such case, the maximum time period of energy release $\Delta t_1$ is determined as equation (10).

$$\Delta t_1 = \frac{J\omega_N^2 - J\omega^2}{2(1-s)P_e} \approx \frac{J\omega_N^2 - J\omega_{min}^2}{2P_e} \qquad (10)$$

Referring to the aforementioned illustration, the active power $P_r$ flowing through the rotor of the doubly-fed asynchronous generator is s times the active power $P_e$ flowing through the stator. Therefore, the difference between the active power $P_e$ flowing through the stator of the doubly-fed asynchronous generator and the active power $P_r$ flowing through the rotor of the doubly-fed asynchronous generator is converted into the increased angular acceleration and rotational momentum of the rotor, and is accumulated as the increased kinetic energy of the rotor during the whole process of the primary frequency adjustment. In such case, during the process of the primary frequency adjustment, the angular velocity of the rotor of the new energy support machine is in a monotonically increasing dynamic process, and the slip ratio is a positive value that is larger than 0 and less than the upper threshold. When the active power $P_e$ adopts the permissible maximum active power flowing through the stator of the doubly-fed asynchronous generator, during the process of the primary frequency adjustment, in a limiting case that the angular velocity of the rotor increases from the initial state (rated angular velocity $\omega_N$) to the upper threshold of angular velocity $\omega_{max}$, the kinetic energy of the rotor of the doubly-fed asynchronous generator increases the most, and the primary frequency adjustment lasts for the longest time period. In such case, the maximum time period of energy absorption $\Delta t_2$ is determined as equation (11).

$$\Delta t_2 = \frac{J\omega^2 - J\omega_N^2}{2(1-s)P_e} \approx \frac{J\omega_{max}^2 - J\omega_N^2}{2P_e} \qquad (11)$$

In some optional implementations, as shown in equation (12), the larger one of the maximum time period of energy release $\Delta t_1$ and the maximum time period of energy absorption $\Delta t_2$ is taken as the upper threshold of the integration time $t_{max}$, and then the capacity of the energy storage apparatus is determined by integral. The determined capacity value of the energy storage apparatus is larger and more reliable, and thus has a better engineering practicality.

$$t_{max} = \max\left\{\Delta t_1, \Delta t_2\right\} \qquad (12)$$

The determined capacity may cover the energy that needs to be obtained from the energy storage apparatus or released to the energy storage apparatus in the limiting case during the primary frequency adjustment, such that the rotor of the doubly-fed asynchronous generator and the energy storage apparatus participate in the primary frequency adjustment collaboratively, and the charging and discharging duration of the energy storage apparatus disposed on the DC side of the frequency converter may be not less than the maximum duration for which the rotor of the doubly-fed asynchronous generator participates in the primary frequency adjustment.

In summary, the method for determining the capacity of the energy storage apparatus comprehensively takes into account the limiting conditions in the operation of the power grid, and has a high coverage of the operation profile of the power grid. The method is intuitive and reliable, and has a small calculation amount, a low demand for computational resources, a high solving efficiency and a good accuracy.

As shown in FIG. 2, an apparatus 200 for determining a capacity of an energy storage apparatus for a new energy support machine of an embodiment of the disclosure includes a duration determination unit 210, a slip ratio determination unit 220 and a capacity determination unit 230.

The duration determination unit 210 is configured to determine a duration for which a rotor of a doubly-fed asynchronous generator participates in an adjustment.

The slip ratio determination unit 220 is configured to determine a slip ratio of the rotor of the doubly-fed asynchronous generator when the rotor participates in the adjustment.

The capacity determination unit 230 is configured to determine the capacity of the energy storage apparatus according to active power when a stator of the doubly-fed asynchronous generator participates in the adjustment, the slip ratio of the rotor when the rotor participates in the adjustment, and the duration for which the rotor participates in the adjustment.

In some optional implementations, the duration determination unit 210 being configured to determine the duration for which the rotor of the doubly-fed asynchronous generator participates in the adjustment includes that the duration determination unit 210 is configured to:

determine a maximum time period of energy release by the rotor of the doubly-fed asynchronous generator according to a lower threshold of an angular velocity of the rotor of the doubly-fed asynchronous generator;

determine a maximum time period of energy absorption by the rotor of the doubly-fed asynchronous generator according to an upper threshold of the angular velocity of the rotor of the doubly-fed asynchronous generator; and

determine a larger one of the maximum time period of energy release and the maximum time period of energy absorption as the duration for which the rotor participates in the adjustment.

In some optional implementations, the slip ratio determination unit 220 being configured to determine the slip ratio of the rotor of the doubly-fed asynchronous generator when the rotor participates in the adjustment includes that the slip ratio determination unit 220 is configured to:

determine an angular velocity of the rotor when the rotor participates in the adjustment according to a kinetic equation of the rotor of the doubly-fed asynchronous generator; and

determine the slip ratio of the rotor when the rotor participates in the adjustment according to a rated angular velocity of the rotor of the doubly-fed asynchronous generator and the angular velocity of the rotor when the rotor participates in the adjustment.

In some optional implementations, the apparatus 200 further includes a stator active power determination unit (not shown in the figure).

The stator active power determination unit is configured to determine the active power when the stator participates in the adjustment according to an obtained to-be-adjusted frequency deviation of a system frequency and a frequency-active adjustment coefficient corresponding to the doubly-fed asynchronous generator.

In some optional implementations, the capacity determination unit 230 being configured to determine the capacity of the energy storage apparatus includes that the capacity determination unit 230 is configured to:

integrate the active power when the stator participates in the adjustment and the slip ratio of the rotor when the rotor participates in the adjustment during the duration for which the rotor participates in the adjustment to obtain an integral result. The integral result is the capacity of the energy storage apparatus.

The above capacity determination apparatus 200 has the same technical solution and technical effect as the aforementioned capacity determination method, and will not be repeated.

The computer storage medium of an embodiment of the disclosure has stored thereon a computer program. The computer program is configured to implement any one of the methods illustrated above.

An embodiment of the disclosure provides an electrochemical energy storage apparatus. The electrochemical energy storage apparatus is disposed in a new energy support machine, and the new energy support machine is disposed at a grid connection point of a new energy station. The new energy support machine is further equipped with a doubly-fed asynchronous generator and a frequency converter. The energy storage apparatus is disposed on a DC side of the frequency converter, and the frequency converter adjusts active power flowing through at least one of a stator or a rotor of the doubly-fed asynchronous generator. A capacity of the energy storage apparatus is determined according to any one of the methods illustrated above.

An embodiment of the disclosure provides a new energy support machine. The new energy support machine is disposed at a grid connection point of a new energy station, and the new energy support machine participates in an adjustment of a system frequency by releasing or absorbing active power. The new energy support machine includes the electrochemical energy storage apparatus illustrated above.

It is to be understood by those skilled in the art that embodiments of the disclosure may be provided as methods, systems, or computer program products. Therefore, the disclosure may adopt the form of a fully hardware embodiment, the form of a fully software embodiment, or the form of combining embodiments in software and hardware aspects. Furthermore, the disclosure may adopt the form of a computer program product implemented on one or more computer-usable storage media (which includes, but is not limited to a disk memory, a Compact Disc Read-Only Memory (CD-ROM), an optical memory, or the like) that contain computer-usable program codes therein.

The disclosure is described with reference to flowcharts and/or block diagrams according to methods, devices (systems), and computer program products of the embodiments of the disclosure. It is to be understood that each of the flows and/or blocks in the flowchart and/or block diagram, and a combination of flows and/or blocks in the flowchart and/or block diagram, may be implemented by computer program instructions. These computer program instructions may be provided to a processor of a general purpose computer, a special purpose computer, an embedded processor, or other programmable data processing devices, to produce a machine, such that instructions executed by the processor of a computer or other programmable data processing devices can produce an apparatus for implementing functions specified in one or more flows in the flowchart and/or one or more blocks in the block diagram.

These computer program instructions may also be stored in a computer-readable memory that may direct a computer or other programmable data processing devices to operate in a particular manner, such that instructions stored in the computer-readable memory produce a manufactured product including an instruction apparatus, and the instruction apparatus implements functions specified in one or more flows in the flowchart and/or one or more blocks in the block diagram.

These computer program instructions may also be loaded onto a computer or other programmable data processing devices, such that a series of operation steps are executed on the computer or other programmable devices to produce computer-implemented processing, and thus instructions executed on the computer or other programmable devices provide steps for implementing functions specified in one or more flows in the flowchart and/or one or more blocks in the block diagram.

Generally, all terms used in the claims are explained according to the ordinary meaning in the art, unless otherwise expressly defined therein. All references to "a/the [apparatus, assembly, or the like]" are openly explained as at least one example of the apparatus, assembly, or the like, unless otherwise explicitly illustrated. It is not necessary for the steps of any method disclosed herein to be run in the disclosed exact order, unless explicitly illustrated.

**Claims**

1. A method for determining a capacity of an energy storage apparatus for a new energy support machine, comprising:

    determining (S110) a duration for which a rotor of a doubly-fed asynchronous generator participates in an adjustment;
    determining (S120) a slip ratio of the rotor of the doubly-fed asynchronous generator when the rotor participates in the adjustment; and
    determining (S130) the capacity of the energy storage apparatus according to active power when a stator of the doubly-fed asynchronous generator participates in the adjustment, the slip ratio of the rotor when the rotor participates in the adjustment, and the duration for which the rotor participates in the adjustment,
    **characterized in that**
    determining the capacity of the energy storage apparatus comprises:
    integrating the active power when the stator participates in the adjustment and the slip ratio of the rotor when the rotor participates in the adjustment during the duration for which the rotor participates in the adjustment to obtain an integral result, wherein the integral result is the capacity of the energy storage apparatus.

2. The method of claim 1, wherein determining the duration for which the rotor of the doubly-fed asynchronous generator participates in the adjustment comprises:

    determining, according to a lower threshold of an angular velocity of the rotor of the doubly-fed asynchronous generator, a maximum time period of energy release by the rotor of the doubly-fed asynchronous generator;
    determining, according to an upper threshold of the angular velocity of the rotor of the doubly-fed asynchronous generator, a maximum time period of energy absorption by the rotor of the doubly-fed asynchronous generator; and
    determining a larger one of the maximum time period of energy release and the maximum time period of energy absorption as the duration for which the rotor participates in the adjustment.

3. The method of claim 1, wherein determining the slip ratio of the rotor of the doubly-fed asynchronous generator when the rotor participates in the adjustment comprises:

    determining, according to a kinetic equation of the rotor of the doubly-fed asynchronous generator, an angular velocity of the rotor when the rotor participates in the adjustment; and
    determining, according to a rated angular velocity of the rotor of the doubly-fed asynchronous generator and the angular velocity of the rotor when the rotor participates in the adjustment, the slip ratio of the rotor when the rotor participates in the adjustment.

4. The method of claim 1, further comprising:
    determining the active power when the stator participates in the adjustment according to an obtained to-be-adjusted frequency deviation of a system frequency and a frequency-active adjustment coefficient corresponding to the doubly-fed asynchronous generator.

5. The method of any one of claims 1 to 4, wherein the capacity of the energy storage apparatus is an integral value of active power flowing through the rotor over time within the duration for which the rotor of the doubly-fed asynchronous generator participates in the adjustment.

6. An apparatus (200) for determining a capacity of an energy storage apparatus for a new energy support machine, comprising:

a duration determination unit (210), configured to determine a duration for which a rotor of a doubly-fed asynchronous generator participates in an adjustment;
a slip ratio determination unit (220), configured to determine a slip ratio of the rotor of the doubly-fed asynchronous generator when the rotor participates in the adjustment; and
a capacity determination unit (230), configured to determine the capacity of the energy storage apparatus according to active power when a stator of the doubly-fed asynchronous generator participates in the adjustment, the slip ratio of the rotor when the rotor participates in the adjustment, and the duration for which the rotor participates in the adjustment,
**characterized in that**
the capacity determination unit being configured to determine the capacity of the energy storage apparatus comprises that the capacity determination unit is configured to:
integrate the active power when the stator participates in the adjustment and the slip ratio of the rotor when the rotor participates in the adjustment during the duration for which the rotor participates in the adjustment to obtain an integral result, wherein the integral result is the capacity of the energy storage apparatus.

7. The apparatus of claim 6, wherein the duration determination unit being configured to determine the duration for which the rotor of the doubly-fed asynchronous generator participates in the adjustment comprises that the duration determination unit is configured to:

determine, according to a lower threshold of an angular velocity of the rotor of the doubly-fed asynchronous generator, a maximum time period of energy release by the rotor of the doubly-fed asynchronous generator;
determine, according to an upper threshold of the angular velocity of the rotor of the doubly-fed asynchronous generator, a maximum time period of energy absorption by the rotor of the doubly-fed asynchronous generator; and
determine a larger one of the maximum time period of energy release and the maximum time period of energy absorption as the duration for which the rotor participates in the adjustment.

8. The apparatus of claim 6, wherein the slip ratio determination unit being configured to determine the slip ratio of the rotor of the doubly-fed asynchronous generator when the rotor participates in the adjustment comprises that the slip ratio determination unit is configured to:

determine, according to a kinetic equation of the rotor of the doubly-fed asynchronous generator, an angular velocity of the rotor when the rotor participates in the adjustment; and
determine, according to a rated angular velocity of the rotor of the doubly-fed asynchronous generator and the angular velocity of the rotor when the rotor participates in the adjustment, the slip ratio of the rotor when the rotor participates in the adjustment.

9. The apparatus of claim 6, further comprising:
a stator active power determination unit, configured to determine the active power when the stator participates in the adjustment according to an obtained to-be-adjusted frequency deviation of a system frequency and a frequency-active adjustment coefficient corresponding to the doubly-fed asynchronous generator.

10. A computer storage medium having stored thereon a computer program, the computer program being configured to implement the method of any one of claims 1 to 5.

11. An electrochemical energy storage apparatus, wherein the electrochemical energy storage apparatus is disposed in a new energy support machine;

wherein the new energy support machine is disposed at a grid connection point of a new energy station;
the new energy support machine is further equipped with a doubly-fed asynchronous generator and a frequency converter;
the energy storage apparatus is disposed on a Direct Current, DC, side of the frequency converter; and the frequency converter adjusts active power flowing through at least one of a stator or a rotor of the doubly-fed asynchronous generator; and wherein the electrochemical energy storage apparatus comprises the apparatus (200) for determining a capacity of the energy storage apparatus according to claim 6 configured to determine the capacity of the energy storage apparatus according to the method for determining the capacity of the energy storage apparatus of any one of claims 1 to 5.

12. A new energy support machine, wherein the new energy support machine is disposed at a grid connection point of a new energy station, and

the new energy support machine participates in an adjustment of a system frequency by releasing or absorbing active power; and
wherein the new energy support machine comprises:
the electrochemical energy storage apparatus of claim 11.

**Patentansprüche**

1. Verfahren zum Bestimmen einer Kapazität einer Energiespeicherungseinrichtung für eine neue Energieträgermaschine, umfassend:

Bestimmen (S110) einer Dauer, für die ein Rotor eines doppelt gespeisten asynchronen Generators an einer Regelung teilnimmt;
Bestimmen (S120) eines Schlupfverhältnisses des Rotors des doppelt gespeisten asynchronen Generators, wenn der Rotor an der Regelung teilnimmt; und
Bestimmen (S130) der Kapazität der Energiespeicherungseinrichtung gemäß der Wirkleistung, wenn ein Stator des doppelt gespeisten asynchronen Generators an der Regelung teilnimmt, dem Schlupfverhältnis des Rotors, wenn der Rotor an der Regelung teilnimmt, und der Dauer, während der der Rotor an der Regelung teilnimmt, **dadurch gekennzeichnet, dass**
das Bestimmen der Kapazität der Energiespeicherungseinrichtung umfasst:
Integrieren der Wirkleistung, wenn der Stator an der Regelung teilnimmt, und des Schlupfverhältnisses des Rotors, wenn der Rotor an der Regelung teilnimmt, über die Dauer, während der der Rotor an der Regelung teilnimmt, um ein integrales Ergebnis zu erhalten, wobei das integrale Ergebnis die Kapazität der Energiespeicherungseinrichtung ist.

2. Verfahren nach Anspruch 1, wobei das Bestimmen der Dauer, während der der Rotor des doppelt gespeisten asynchronen Generators an der Regelung teilnimmt, umfasst:

Bestimmen, gemäß einem unteren Schwellenwert einer Winkelgeschwindigkeit des Rotors des doppelt gespeisten asynchronen Generators, einer maximalen Zeitspanne der Energieabgabe durch den Rotor des doppelt gespeisten asynchronen Generators;
Bestimmen, gemäß einem oberen Schwellenwert der Winkelgeschwindigkeit des Rotors des doppelt gespeisten asynchronen Generators, einer maximalen Zeitspanne der Energieaufnahme durch den Rotor des doppelt gespeisten asynchronen Generators; und
Bestimmen einer größeren der maximalen Zeitspanne der Energieabgabe und der maximalen Zeitspanne der Energieaufnahme als die Dauer, während der der Rotor an der Regelung teilnimmt.

3. Verfahren nach Anspruch 1, wobei das Bestimmen des Schlupfverhältnisses des Rotors des doppelt gespeisten asynchronen Generators, wenn der Rotor an der Regelung teilnimmt, umfasst:

Bestimmen einer Winkelgeschwindigkeit des Rotors gemäß einer kinetischen Gleichung des Rotors des doppelt gespeisten asynchronen Generators, wenn der Rotor an der Regelung teilnimmt; und
Bestimmen des Schlupfverhältnisses des Rotors, wenn der Rotor an der Regelung teilnimmt, gemäß einer Nennwinkelgeschwindigkeit des Rotors des doppelt gespeisten asynchronen Generators und der Winkelgeschwindigkeit des Rotors, wenn der Rotor an der Regelung teilnimmt.

4. Verfahren nach Anspruch 1, ferner umfassend:
Bestimmen der Wirkleistung, wenn der Stator an der Regelung gemäß einer erhaltenen zu regelnden Frequenzabweichung einer Systemfrequenz und einem frequenz-wirkleistungsbezogenen Regelungskoeffizienten entsprechend dem doppelt gespeisten asynchronen Generator teilnimmt.

5. Verfahren nach einem der Ansprüche 1 bis 4, wobei die Kapazität der Energiespeicherungseinrichtung ein integraler Wert der durch den Rotor fließenden Wirkleistung im Laufe der Zeit innerhalb der Dauer liegt, für die der Rotor des doppelt gespeisten asynchronen Generators an der Regelung teilnimmt.

6. Einrichtung (200) zum Bestimmen einer Kapazität einer Energiespeicherungseinrichtung für eine neue Energieträgermaschine, umfassend:

eine Zeitdauerbestimmungseinheit (210), die konfiguriert ist, um eine Zeitdauer zu bestimmen, für die ein Rotor eines doppelt gespeisten asynchronen Generators an einer Regelung teilnimmt;
eine Schlupfverhältnisbestimmungseinheit (220), die konfiguriert ist, um ein Schlupfverhältnis des Rotors des doppelt gespeisten asynchronen Generators zu bestimmen, wenn der Rotor an der Regelung teilnimmt; und
eine Kapazitätsbestimmungseinheit (230), die konfiguriert ist, um die Kapazität der Energiespeicherungseinrichtung gemäß der Wirkleistung zu bestimmen, wenn ein Stator des doppelt gespeisten asynchronen Generators an der Regelung teilnimmt, dem Schlupfverhältnis des Rotors, wenn der Rotor an der Regelung teilnimmt, und der Zeitdauer, während der der Rotor an der Regelung teilnimmt,
**dadurch gekennzeichnet, dass**
die Kapazitätsbestimmungseinheit, die konfiguriert ist, um die Kapazität der Energiespeicherungseinrichtung zu bestimmen, umfasst, dass die Kapazitätsbestimmungseinheit konfiguriert ist zum:
Integrieren der Wirkleistung, wenn der Stator an der Regelung teilnimmt, und des Schlupfverhältnisses des Rotors, wenn der Rotor an der Regelung teilnimmt, über die Dauer, während der der Rotor an der Regelung teilnimmt, um ein integrales Ergebnis zu erhalten, wobei das integrale Ergebnis die Kapazität der Energiespeicherungseinrichtung ist.

7. Einrichtung nach Anspruch 6, wobei die Zeitdauerbestimmungseinheit, die konfiguriert ist, um die Zeitdauer zu bestimmen, während der der Rotor des doppelt gespeisten asynchronen Generators an der Regelung teilnimmt, umfasst, dass die Zeitdauerbestimmungseinheit konfiguriert ist zum:

Bestimmen, gemäß einem unteren Schwellenwert einer Winkelgeschwindigkeit des Rotors des doppelt gespeisten asynchronen Generators, einer maximalen Zeitspanne der Energieabgabe durch den Rotor des doppelt gespeisten asynchronen Generators;
Bestimmen, gemäß einem oberen Schwellenwert der Winkelgeschwindigkeit des Rotors des doppelt gespeisten asynchronen Generators, einer maximalen Zeitspanne der Energieaufnahme durch den Rotor des doppelt gespeisten asynchronen Generators; und
Bestimmen einer größeren der maximalen Zeitspanne der Energieabgabe und der maximalen Zeitspanne der Energieaufnahme als die Dauer, während der der Rotor an der Regelung teilnimmt.

8. Einrichtung nach Anspruch 6, wobei die Schlupfverhältnisbestimmungseinheit, die konfiguriert ist, um das Schlupfverhältnis des Rotors des doppelt gespeisten asynchronen Generators zu bestimmen, wenn der Rotor an der Regelung teilnimmt, umfasst, dass die Schlupfverhältnisbestimmungseinheit konfiguriert ist zum:

Bestimmen einer Winkelgeschwindigkeit des Rotors gemäß einer kinetischen Gleichung des Rotors des doppelt gespeisten asynchronen Generators, wenn der Rotor an der Regelung teilnimmt; und
Bestimmen des Schlupfverhältnisses des Rotors, wenn der Rotor an der Regelung teilnimmt, gemäß einer Nennwinkelgeschwindigkeit des Rotors des doppelt gespeisten asynchronen Generators und der Winkelgeschwindigkeit des Rotors, wenn der Rotor an der Regelung teilnimmt.

9. Einrichtung nach Anspruch 6, ferner umfassend:
eine Bestimmungseinheit zur Wirkleistung des Stators, die konfiguriert ist, um gemäß einer erhaltenen zu regelnden Frequenzabweichung einer Systemfrequenz und einem frequenz-wirkleistungsbezogenen Regelungskoeffizienten, der dem doppelt gespeisten Asynchrongenerator entspricht, die Wirkleistung zu bestimmen, wenn der Stator an der Regelung teilnimmt.

10. Computerspeicherungsmedium, das ein darauf gespeichertes Computerprogramm aufweist, wobei das Computerprogramm konfiguriert ist, um das Verfahren nach einem der Ansprüche 1 bis 5 auszuführen.

11. Elektrochemische Energiespeicherungseinrichtung, wobei die elektrochemische Energiespeicherungseinrichtung in einer neuen Energieträgermaschine angeordnet ist;

wobei die neue Energieträgermaschine an einer Netzverbindungsstelle einer neuen Energiestation angeordnet ist;

die neue Energieträgermaschine ferner mit einem doppelt gespeisten asynchronen Generator und einem Frequenzumrichter ausgestattet ist;

die Energiespeicherungseinrichtung auf einer Gleichstromseite (DC-Seite) des Frequenzumrichters angeordnet ist; und der Frequenzumrichter die durch mindestens einen von einem Stator oder einem Rotor des doppelt gespeisten asynchronen Generators fließende Wirkleistung regelt; und

wobei die elektrochemische Energiespeicherungseinrichtung die Einrichtung (200) zum Bestimmen einer Kapazität der Energiespeicherungseinrichtung nach Anspruch 6 umfasst, die konfiguriert ist, um die Kapazität der Energiespeicherungseinrichtung nach dem Verfahren zum Bestimmen der Kapazität der Energiespeicherungseinrichtung nach einem der Ansprüche 1 bis 5 zu bestimmen.

12. Neue Energieträgermaschine, wobei die neue Energieträgermaschine an einer Netzverbindungsstelle einer neuen Energiestation angeordnet ist, und

die neue Energieträgermaschine an einer Regelung einer Systemfrequenz durch Abgeben oder Aufnehmen von Wirkleistung teilnimmt; und

wobei die neue Energieträgermaschine umfasst:

die elektrochemische Energiespeicherungseinrichtung nach Anspruch 11.

**Revendications**

1. Procédé permettant de déterminer une capacité d'un appareil de stockage d'énergie pour une machine de support d'énergie nouvelle, comprenant :

la détermination (S110) d'une durée pendant laquelle un rotor d'un générateur asynchrone à double alimentation participe à un ajustement ;

la détermination (S120) d'un rapport de glissement du rotor du générateur asynchrone à double alimentation lorsque le rotor participe à l'ajustement ; et

la détermination (S130) de la capacité de l'appareil de stockage d'énergie selon une puissance active lorsqu'un stator du générateur asynchrone à double alimentation participe à l'ajustement, le rapport de glissement du rotor lorsque le rotor participe à l'ajustement, et la durée pendant laquelle le rotor participe à l'ajustement, **caractérisé en ce que**

la détermination de la capacité de l'appareil de stockage d'énergie comprend :

l'intégration de la puissance active lorsque le stator participe à l'ajustement et du rapport de glissement du rotor lorsque le rotor participe à l'ajustement pendant la durée pendant laquelle le rotor participe à l'ajustement afin d'obtenir un résultat intégral, dans lequel le résultat intégral est la capacité de l'appareil de stockage d'énergie.

2. Procédé selon la revendication 1, dans lequel la détermination de la durée pendant laquelle le rotor du générateur asynchrone à double alimentation participe à l'ajustement comprend :

la détermination, selon un seuil inférieur d'une vitesse angulaire du rotor du générateur asynchrone à double alimentation, d'une période de temps maximale de libération d'énergie par le rotor du générateur asynchrone à double alimentation ;

la détermination, selon un seuil supérieur de la vitesse angulaire du rotor du générateur asynchrone à double alimentation, d'une période de temps maximale d'absorption d'énergie par le rotor du générateur asynchrone à double alimentation ; et

la détermination d'une plus longue période de temps de la période de temps maximale de libération d'énergie et de la période de temps maximale d'absorption d'énergie en tant que durée pendant laquelle le rotor participe à l'ajustement.

3. Procédé selon la revendication 1, dans lequel la détermination du rapport de glissement du rotor du générateur asynchrone à double alimentation lorsque le rotor participe à l'ajustement comprend :

la détermination, selon une équation cinétique du rotor du générateur asynchrone à double alimentation, d'une vitesse angulaire du rotor lorsque le rotor participe à l'ajustement ; et

la détermination, selon une vitesse angulaire nominale du rotor du générateur asynchrone à double alimentation et la vitesse angulaire du rotor lorsque le rotor participe à l'ajustement, du rapport de glissement du rotor lorsque le rotor participe à l'ajustement.

4. Procédé selon la revendication 1, comprenant en outre :
la détermination de la puissance active lorsque le stator participe à l'ajustement selon un écart de fréquence à ajuster obtenu d'une fréquence système de et un coefficient d'ajustement actif en fréquence correspondant au générateur asynchrone à double alimentation.

5. Procédé selon l'une quelconque des revendications 1 à 4, dans lequel la capacité de l'appareil de stockage d'énergie est une valeur intégrale d'une puissance active circulant à travers le rotor au fil du temps pendant la durée pendant laquelle le rotor du générateur asynchrone à double alimentation participe à l'ajustement.

6. Appareil (200) permettant de déterminer une capacité d'un appareil de stockage d'énergie pour une machine de support d'énergie nouvelle, comprenant :

une unité de détermination de durée (210), configurée pour déterminer une durée pendant laquelle un rotor d'un générateur asynchrone à double alimentation participe à un ajustement ;
une unité de détermination de rapport de glissement (220), configurée pour déterminer un rapport de glissement du rotor du générateur asynchrone à double alimentation lorsque le rotor participe à l'ajustement ; et
une unité de détermination de capacité (230), configurée pour déterminer la capacité de l'appareil de stockage d'énergie selon une puissance active lorsqu'un stator du générateur asynchrone à double alimentation participe à l'ajustement, le rapport de glissement du rotor lorsque le rotor participe à l'ajustement, et la durée pendant laquelle le rotor participe à l'ajustement,
**caractérisé en ce que**
l'unité de détermination de capacité qui est configurée pour déterminer la capacité de l'appareil de stockage d'énergie comprend le fait que l'unité de détermination de capacité est configurée pour :
intégrer la puissance active lorsque le stator participe à l'ajustement et le rapport de glissement du rotor lorsque le rotor participe à l'ajustement pendant la durée pendant laquelle le rotor participe à l'ajustement afin d'obtenir un résultat intégral, dans lequel le résultat intégral est la capacité de l'appareil de stockage d'énergie.

7. Appareil selon la revendication 6, dans lequel l'unité de détermination de durée qui est configurée pour déterminer la durée pendant laquelle le rotor du générateur asynchrone à double alimentation participe à l'ajustement comprend le fait que l'unité de détermination de durée est configurée pour :

déterminer, selon un seuil inférieur d'une vitesse angulaire du rotor du générateur asynchrone à double alimentation, une période de temps maximale de libération d'énergie par le rotor du générateur asynchrone à double alimentation ;
déterminer, selon un seuil supérieur de la vitesse angulaire du rotor du générateur asynchrone à double alimentation, une période de temps maximale d'absorption d'énergie par le rotor du générateur asynchrone à double alimentation ; et
déterminer une plus longue période de temps de la période de temps maximale de libération d'énergie et de la période de temps maximale d'absorption d'énergie en tant que durée pendant laquelle le rotor participe à l'ajustement.

8. Appareil selon la revendication 6, dans lequel l'unité de détermination de rapport de glissement qui est configurée pour déterminer le rapport de glissement du rotor du générateur asynchrone à double alimentation lorsque le rotor participe à l'ajustement comprend le fait que l'unité de détermination de rapport de glissement est configurée pour :

déterminer, selon une équation cinétique du rotor du générateur asynchrone à double alimentation, une vitesse angulaire du rotor lorsque le rotor participe à l'ajustement ; et
déterminer, selon une vitesse angulaire nominale du rotor du générateur asynchrone à double alimentation et la vitesse angulaire du rotor lorsque le rotor participe à l'ajustement, le rapport de glissement du rotor lorsque le rotor participe à l'ajustement.

9. Appareil selon la revendication 6, comprenant en outre :
une unité de détermination de puissance active de stator, configurée pour déterminer la puissance active lorsque le stator participe à l'ajustement selon un écart de fréquence à ajuster obtenu d'une fréquence système de et un coefficient d'ajustement actif en fréquence correspondant au générateur asynchrone à double alimentation.

10. Support de stockage informatique sur lequel est stocké un programme informatique, le programme informatique étant configuré pour mettre en œuvre le procédé selon l'une quelconque des revendications 1 à 5.

11. Appareil de stockage d'énergie électrochimique, dans lequel l'appareil de stockage d'énergie électrochimique est disposé dans une machine de support d'énergie nouvelle ;

dans lequel la machine de support d'énergie nouvelle est disposée au niveau d'un point de connexion au réseau d'une station d'énergie nouvelle ;
la machine de support d'énergie nouvelle est en outre pourvue d'un générateur asynchrone à double alimentation et d'un convertisseur de fréquence ;
l'appareil de stockage d'énergie est disposé sur un côté courant continu, CC, du convertisseur de fréquence ; et le convertisseur de fréquence ajuste une puissance active circulant à travers au moins l'un d'un stator ou d'un rotor du générateur asynchrone à double alimentation ; et
dans lequel l'appareil de stockage d'énergie électrochimique comprend l'appareil (200) permettant de déterminer une capacité de l'appareil de stockage d'énergie selon la revendication 6, configuré pour déterminer la capacité de l'appareil de stockage d'énergie selon le procédé permettant de déterminer la capacité de l'appareil de stockage d'énergie selon l'une quelconque des revendications 1 à 5.

12. Machine de support d'énergie nouvelle, dans laquelle la machine de support d'énergie nouvelle est disposée au niveau d'un point de connexion au réseau d'une station d'énergie nouvelle, et

la machine de support d'énergie nouvelle participe à un ajustement d'une fréquence de système en libérant ou en absorbant une puissance active ; et
dans laquelle la machine de support d'énergie nouvelle comprend :
l'appareil de stockage d'énergie électrochimique selon la revendication 11.

S110

A duration for which a rotor of a doubly-fed asynchronous generator participates in an adjustment is determined

S120

A slip ratio of the rotor of the doubly-fed asynchronous generator when the rotor participates in the adjustment is determined

S130

The capacity of the energy storage apparatus is determined according to active power when a stator of the doubly-fed asynchronous generator participates in the adjustment

**FIG. 1**

Apparatus for determining a capacity of an energy storage apparatus 200

Duration determination unit 210

Slip ratio determination unit 220

Capacity determination unit 230

**FIG. 2**

**FIG. 3**

Grid-side converter

Machine-side converter

Excitation transformer side

Rotor side

Bidirectional DC-DC converter

Energy storage apparatus

FIG. 4

**REFERENCES CITED IN THE DESCRIPTION**

**Patent documents cited in the description**

- CN 112383071 A

**Non-patent literature cited in the description**

- *The Coordinated Control Strategy of Doubly-fed Induction Generators With an Energy Storage Dynamic Voltage Restorer for Low Voltage Ride Through*

- *Analysis of Electromechanical Interactions in a Flywheel System With a Doubly Fed Induction Machine*